# EUROPEAN PATENT APPLICATION

(11) **EP 3 361 839 A1**
(43) Date of publication of application: **15.08.2018**
(21) Application number: 17155958.6
(22) Date of filing: 14.02.2017
(51) Int. Cl.: H05K 3/00, H05K 1/03

(54) **MULTIPLE SUBSTRATE AND METHOD FOR ITS FABRICATION**

(71) Applicant: Infineon Technologies AG, 85579 Neubiberg (DE)
(72) Inventor: Roth, Alexander, 93197 Zeitlarn (DE)
(74) Representative: Lohmanns, Bernard

(57) **Abstract**

The invention relates to a multiple substrate (1, 11, 14, 18) with a brittle-fracture plate or a brittle-fracture layer (2) forming at least two single substrates (3, 12, 15, 19) integrally adjoining each other, which are adjoining each other by at least one predetermined fractural line (4) provided in the brittle-fracture layer (2). Bordering the predetermined fracture line (4), at least one aperture (9, 13, 16, 20) is inserted in the brittle-fracture layer (2), which it completely perforates, and which aperture materially separates the single substrates (3, 12, 15, 19) which are adjoining each other via the predetermined fracture line (4).

The invention also relates to a method for fabricating such a multiple substrate (1, 11, 14, 18).

## Description

The present invention relates to a multiple substrate according to the generic part of Claim 1 and a method for its fabrication according to the generic part of Claim 9.

It is known to fabricate substrates, in particular those with a ceramic insulation or carrier layer such as aluminum oxide ceramics or aluminum nitride ceramics, in multiple application, which means as a multiple substrate with a number of individual applications or single substrates on a common insulation and carrier layer, and where applicable also to equip it with electronic circuit boards, whereby the multiple substrate is separated or singulated. In multiple substrates with a ceramic insulation or carrier layer, this singulation is especially done by cutting, particularly by means of a laser, along cutting lines delimiting the single substrates and/or by fracturing along the cutting lines or predetermined fracture lines.

Such multiple substrates are described, for example, in DE 195 04 378 A1 and DE 44 44 680 A1.

The above named ceramic substrates are used to manufacture electric circuits, in particular power circuits, and preferably in the field of power semiconductor modules. A ceramic plate or ceramic layer, for example made of aluminum oxide ceramics or aluminum nitride ceramics, is metallized on at least one of its surfaces such as the top or bottom side, whereby into at least one metallized side a circuit structure is inserted such as conductor paths, contact and/or connector surfaces produced, for example, by means of scribing processes. Such metallized ceramic substrates are used, for example, as circuit carriers for power electronic modules in which they provide the thermal and the mechanical connection as well as electrical insulation.

For an economical fabrication of the electric circuits, it is generally known to produce these circuits as multiple circuit boards, i.e. in particular to structure the metal surfaces to achieve the necessary conductor paths and/or connecting surfaces and the like, but also to place the electronic components onto the multiple circuit board which is then, after completion of structuring or placement, separated into the various single substrates.

Known multiple substrates usually have a rectangular flat shape on which several single substrates are arranged in matrix or checker-board fashion with equally designed outer contours. Due to their symmetrical shape, there is a risk that after singulation, the single substrates with a rectangular or even square outer contour are accidentally rotated and/or turned onto their back, which can then no longer be recognized by their outer contour alone.

For that reason, it is also known to provide the single substrate with a Poka Yoke in the shape of a bevelled corner to eliminate the symmetry of the square or rectangular single substrate.

Furthermore, all the corners of each single substrate can be bevelled, such that when they are used and incorporated in a power electronic module, they will save space and/or have a better fit. For example, such an essentially rectangular single substrate with bevelled corners is presented in DE 93 10 299 U1. Here, the said single substrates are obtained from a multiple substrate containing several of these, by first inserting predetermined fracture lines into the multiple substrate, which delineate the single substrates, for example by laser scribing or mechanical etching, where a groove matching the predetermined fracture line is produced in the ceramic substrate with a depth of usually up to about 30% to 50% of the cross section of the substrate.

In addition to the long, straight predetermined fracture lines delineating the rectangular form of each single substrate, which essentially intersect each other at right angles, the multiple substrate described in DE 93 19 299 U1 also has diagonal short straight predetermined fracture lines at all corners of each single substrate running at right angles to the long straight predetermined fracture lines, allowing the later separation of the corners. After all predetermined fracture lines are scribed into the multiple substrate, the single substrates can be obtained such that the multiple substrate is first broken along the long predetermined fracture lines intersecting each other at right angles, and then the individual corners of each already singulated single substrate are broken off along the diagonal short predetermined fracture lines.

Inserting the short predetermined fracture lines diagonal to the long predetermined fracture lines at the corners of each single substrate often causes an uncontrolled fracture when such multiple substrates are broken along the long predetermined fracture lines, especially in the areas of the corners of each single substrate, since several diagonal predetermined fracture lines coincide in the corners. In that case, the fracture edge no longer runs only along the straight long predetermined fracture line, but "fringes" out, particularly in the corner areas (hereinafter also called uncontrolled fracturing), which makes it very difficult and time-consuming to subsequently remove the corners, since, for example, they can no longer be removed manually if they are below a certain size.

Against this background, it is the object of the present invention to provide a multiple substrate and a method for fabricating a multiple substrate which eliminates the aforementioned disadvantages. Furthermore, the invention is to facilitate a more efficient and more cost-effective fabrication of the multiple substrate and the single substrates to be obtained therefrom.

This object is achieved by a multiple substrate with the characteristics of Claim 1 and by a method of fabricating a multiple substrate with the characteristics of Claim 9. Other especially advantageous embodiments of the invention are disclosed by the various subclaims.

It should be noted that the individual characteristics mentioned in the following description could be combined with each other in any technically feasible manner to form other embodiments of the invention. In particular, the description also characterizes and specifies the invention in connection with the figures.

It should also be noted that the invention described below can be used for any kind of brittle-fracture substrate, for example for ceramic substrates such as AIN (aluminum nitride), Si₃N₄ (silicon nitride), Al₂O₃ (aluminum oxide) and the like, but also for all other brittle-fracture substances used as carrier material such as glass. In general, a brittle-fracture material as defined in the present invention for a substrate is defined, in contrast to ductile materials, as a material that fractures near its elasticity limit without or with only marginal plastic deformation. Hereinafter the term "substrate" is used as a synonym for all such types of substrates.

According to the invention, a multiple substrate comprises a brittle-fracture plate such as a ceramic or glass plate, or a brittle-fracture layer such as a ceramic or glass layer, which forms at least two adjoining single substrates integrally adjoining each other. The at least two single substrates are adjoined to each other by at least one predetermined fracture line provided in the brittle-fracture layer. A predetermined fracture line is defined as a line along which the multiple substrate can be broken in a subsequent singulation step to cause a material separation of the single substrates, i.e. to singulate the multiple substrate. To ensure that during singulation, the multiple substrate can be broken in a controlled manner along the predetermined fracture line, the predetermined fracture line is preferably inserted into the brittle-fracture layer in the shape of a groove. This can be produced, for example, by laser scribing or mechanical etching, with the groove preferably having a depth of about 30% to 60% of the substrate's cross section or thickness. Alternatively, other kinds of weakening along the predetermined fracture line, well known to those skilled in the art, can be used to cause a channel for a brittle fracture along the predetermined fracture line.

The invention also provides that adjacent to the predetermined fracture line at least one aperture is inserted into the brittle-fracture layer, which completely perforates the brittle-fracture layer and materially separates the single substrates from each other, which are adjoining each other via the predetermined fracture line. This aperture differs from the predetermined fracture line in that the aperture perforates the brittle-fracture layer completely, i.e. by 100% of the cross section, while the predetermined fracture line only has a depth of preferably 30% to 60% of the substrate's cross section or substrate thickness, and thus provides an integral connection between the single substrates in the multiple substrate. Since by definition, the single substrates in the multiple substrate integrally adjoin each other along the predetermined fracture line, it follows that the aperture bordering the predetermined fracture line has a maximum length along the predetermined fracture line that is always shorter than the entire longitudinal extension of the edge of a single substrate that is determined by the relevant predetermined fracture line. Otherwise, the single substrates adjoining each other via the predetermined fracture line would no longer do so integrally.

The aperture bordering the predetermined fracture line reduces the risk of an uncontrolled fracture along the predetermined fracture line or during singulation of the multiple substrate, especially in the area of the aperture, since the aperture bordering the predetermined fracture line causes a stress concentration in the groove of the predetermined fracture line at the transition to the aperture (notch effect). Thus, the at least one aperture bordering the predetermined fracture line can preferably be arranged in those areas of the multiple substrate where due to the specific course of the predetermined fracture line and/or the overlapping with one or more predetermined fracture lines without at least one aperture, it would be highly probable that an uncontrolled fracture would occur during the singulation of the multiple substrate. Since the possibility of an uncontrolled fracture of the multiple substrate during its singulation is considerably reduced thanks to the inventive provision of at least one aperture bordering the predetermined fracture line, a more efficient and cost-effective fabrication of the multiple substrate and its single substrates becomes possible.

Furthermore, the at least one aperture bordering the predetermined fracture line advantageously reduces the refractive force required for the multiple substrate to fracture along the predetermined fracture line, since the refractive force is proportionate to the length of the predetermined fracture line which is interrupted in its course by the at least one aperture, i.e. shortened in length in comparison with a predetermined fracture line to which no such apertures are bordering.

An advantageous embodiment of the invention provides that at least two predetermined fracture lines intersecting each other are provided on the multiple substrate and at least one aperture is provided at the intersection point of these two predetermined fracture lines. In a special way, the intersection point of the predetermined fracture lines constitutes - with regard to the uncontrolled fracturing during singulation of the multiple substrate - a critical area, especially also in a case where the predetermined fracture lines do not intersect at right angles as happens, for example, in the above described case when at least one bevelled corner of the single substrate can for example form a Poka Yoke. By providing the aperture in exactly that area, the probability of uncontrolled fracturing at the intersection of two predetermined fracture lines during singulation of the multiple substrate can be substantially reduced. Thus, the at least one aperture can be advantageously used also to provide a Poka Yoke at each single substrate, for example in the form of a bevelled or rounded corner of an otherwise rectangular single substrate. Of course, it is also possible to bevel or round off every corner or all but one corner of an otherwise rectangular single substrate by means of an appropriately designed aperture.

Since such a aperture of the brittle-fracture layer is already provided in the multiple substrate at the intersection of two predetermined fracture lines, i.e. at a corner of a single substrate, and does not have to be broken only during singulation of the multiple substrate in an additional work process, as is the case in the above described state of the art, it is possible this way to provide apertures of particularly small dimensions in the multiple substrate, which otherwise could not be fractured, and especially not manually.

It is particularly preferable if the maximum extension of the aperture along the predetermined fracture line has a length that corresponds to half the length of the edges determined by the predetermined fracture lines of the single substrates which adjoin each other via those predetermined fracture lines. It is even more preferable when the extent of the aperture along the predetermined fracture line is a considerably shorter fraction of the length of the edge determined by the predetermined fracture line of the respective single substrate, for example only one tenth. An aperture of such dimension can for example advantageously be used on each corner of a single substrate, which for example would otherwise be rectangular.

Another advantageous embodiment of the invention provides that the multiple substrate comprises at least one group of at least four single substrates which have a common intersection point formed by at least two intersecting predetermined fracture lines, where all single substrates of the group border each other, whereby each group only has one aperture which is provided at the common intersection point. For example, the multiple substrate can have only one group of at least four single substrates arranged around a common intersection point, whereby this group has only one aperture provided at the common intersection point. If for example the multiple substrate has several such groups bordering each other, each such group of single substrates has only one aperture provided at its respective common intersection point. The special advantage of that embodiment of the multiple substrate is that the at least four single substrates belonging to a single group are arranged about the common intersection point where they border each other, can each be provided with a Poka Yoke by means of only one single aperture.

In another advantageous embodiment of the invention, the at least one predetermined fracture line intersects at least one outside edge of the brittle-fracture layer forming the multiple substrate, whereby the aperture in this case is arranged at the intersection point between the predetermined fracture line and the said outside edge. In this case, the outside edge is defined as the outer substrate edge, which delineates the brittle substrate in the multiple substrate.

In addition, at least one further aperture according to the invention, i.e. an aperture that completely perforates the brittle-fracture layer of the multiple substrate, can also be arranged at an intersection point of two intersecting outside edges of the brittle-fracture layer.

Thus, at least one aperture can also be provided bordering an outside edge of the brittle-fracture layer, with the same advantages as explained above for the arrangement of the aperture bordering the at least one predetermined fracture line. In the same manner, at least one such aperture can also be arranged at two intersecting outside edges of the multiple substrate.

In accordance with yet another advantageous embodiment of the invention, the aperture is delineated at least partially by a traverse and/or a curvature. With this, it is possible to advantageously influence as desired the notch effect that is applied to the groove of the predetermined fracture line and/or the outside edge of the brittle-fracture layer, such that the risk of an uncontrolled fracture of the multiple substrate during singulation in the area of the aperture is substantially reduced or even completely eliminated.

According to another aspect of the present invention, a method is provided to fabricate a multiple substrate with a brittle-fracture plate such as a ceramic or glass plate, or a brittle-fracture layer such as a ceramic or glass layer. The method involves inserting at least one predetermined fracture line into the brittle-fracture layer via which at least two single substrates connect with each other. Furthermore, bordering the predetermined fracture line, at least one aperture is inserted in the brittle-fracture layer that completely perforates the brittle-fracture layer and materially separates the single substrates from each other via the predetermined fracture line.

With regard to the definition of terms, advantages and effects of such a method, reference is made to the above description of the device, which also applies accordingly to the manufacturing method.

An advantageous embodiment of the invention provides that the predetermined fracture line and the aperture are inserted into the brittle-fracture layer by means of a single laser such as a CO₂ laser, which is being alternated between a scribing mode for inserting the predetermined fracture line and a cutting mode for inserting the aperture into the brittle-fracture layer. In this manner, the cost of manufacturing the multiple layer can be substantially reduced and fabrication can be made more efficient, which in particular results in a reduction of costs.

Alternatively, however, the multiple substrate can also be produced with two different lasers, in which case a first laser is provided for scribing the at least one predetermined fracture line into the brittle-fracture layer, and a second laser for inserting the at least one aperture into the brittle-fracture layer.

Another advantageous embodiment of the invention provides that at least two intersecting predetermined fracture lines are inserted into the brittle-fracture layer, and the aperture is inserted into the brittle-fracture layer at the intersection point of the predetermined fracture lines.

Furthermore, in yet another advantageous embodiment of the invention, the at least one intersecting predetermined fracture line can be inserted into an outside edge of the brittle-fracture layer by cutting, while the aperture is inserted into the brittle-fracture layer at the point of intersection with the outside edge.

Furthermore, another aperture according to the invention, i.e. an aperture that is completely perforating the brittle-fracture layer of the multiple substrate, can be inserted into the brittle-fracture layer at an intersection point of two intersecting outside edges of the brittle-fracture layer.

According to another advantageous embodiment of the invention, the aperture can be formed at least partially by a traverse and/or a curvature.

Other characteristics and advantages of the invention result from the following description of embodiments of the invention not to be understood as exclusive, which will be explained below in detail, with reference to the schematic drawings where
Fig. 1 shows a top view of a first embodiment of a multiple substrate according to the invention.
Fig. 2 shows a top view of a second embodiment of a multiple substrate according to the invention.
Fig. 3 shows a top view of a third embodiment of a multiple substrate according to the invention.
Fig. 4 shows a top view of a fourth embodiment of a multiple substrate according to the invention.

In the different drawings, parts with the same function are always shown with the same reference numbers, which means they will usually only be described once.

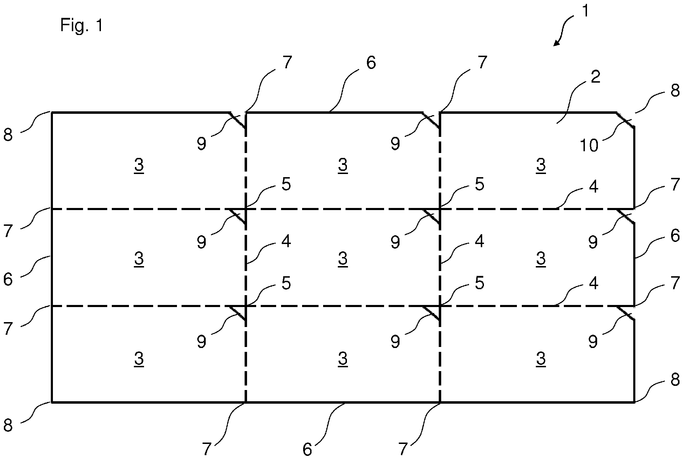

Fig. 1 shows a top view of a first embodiment of an inventive multiple substrate 1 that is essentially rectangular. The multiple substrate 1 comprises a brittle-fracture plate such as a ceramic or glass plate, or a brittle-fracture layer 2 such as a ceramic or glass layer which in the shown example forms a total of nine single substrates 3 integrally adjoining each other, whereby the adjacent single substrates 3 adjoin each other via a predetermined fracture line 4 provided in the brittle-fracture layer 2. In total, four predetermined fracture lines 4 are inserted into the multiple substrate 1 shown in Fig. 1. The predetermined fracture lines 4 are shown as dotted lines. In the embodiment of the shown multiple substrate 1, all predetermined fracture lines 4 are straight, whereby two predetermined fracture lines 4 in Fig. 1 run horizontally and parallel to each other, while two predetermined fracture lines 4 run vertically and parallel to each other. The horizontal predetermined fracture lines 4 intersect the vertical predetermined fracture lines 4 at right angles at the respective intersection points 5. Thus, the essentially rectangular multiple substrate 1 shown in Fig. 1 has a total of nine single substrates 3 which are also essentially of rectangular shape.

Furthermore, the multiple substrate 1 shown in Fig. 1 is delineated at the top and bottom as well as on the left and on the right by a total of four outside edges 6. The two horizontal predetermined fracture lines 4 rectangularly intersect the outside edges 6, which border the multiple substrate 1 on the left and on the right in intersection points 7. The two vertical predetermined fracture lines 4 intersect the multiple substrate 1 at the delineating outside edges 6 at the top and at the bottom. The top outside edge 6 intersects the left and right outside edge 6 rectangularly at further intersection points 8, and the bottom outside edge 6 also intersects the left and right outside edge 6 rectangularly at intersection points 8. The intersection point 8 (top right in Fig 1) of the upper outside edge 6 with the right-hand outside edge 6 of the multiple substrate 1 is only indicated by reference number 8 in the place where the extensions of the respective outside edges 6 would intersect.

Preferably, the predetermined fracture lines 4 of the multiple substrate 1 are inserted into the brittle-fracture layer 2 in the form of a groove. It can, for example, be produced by laser scribing or mechanical etching of brittle-fracture layer 2, whereby the groove preferably has a depth of about 30% to 60% of the substrate cross-section or thickness. Preferably, a CO₂ laser is used for laser scribing.

Also seen in Fig. 1 are apertures 9 bordering the corresponding predetermined fracture lines 4 and completely perforating the brittle-fracture layer 2, which border at least one predetermined fracture line 4. Each aperture 9 materially separates the single substrates 3, which connect each other through the corresponding predetermined fracture line 4. At the intersection point 8 of the top and right-hand outside edge 6 of the multiple substrate 1, another aperture 10 is provided which does not differ substantially from the apertures 9 that border the respective predetermined fracture lines 4 in terms of their design and dimensions, but only borders two outside edges 6 of the multiple substrate 1.

Fig. 1 also shows that the maximum extension of each aperture 9 and 10 along each predetermined fracture line 4 or outside edge 6, has a length which corresponds to clearly less than half of the length of the edges determined by the predetermined fracture lines 5 or outside edges 6 of the single substrates 3 which adjoin each other via these.

Furthermore, Fig. 1 shows that to each single substrate 3 of the shown embodiment of the multiple substrate 1, exactly one aperture 9 or 10 has been assigned whose purpose is to bevel the right top corner of each single substrate 3. The apertures 9 and 10 are always completely delineated by a traverse; in the embodiment, it is shown as a triangular traverse. This form of aperture 9 or 10 represents a Poka Yoke which removes the symmetry of each single substrate 3 such that a layer of each single substrate 3, i.e. the front and back side and a rotation, can be clearly and simply recognized after its singulation from the multiple substrate 1 for subsequent processing steps of single substrate 3.

The apertures 9 bordering the respective predetermined fracture lines 4 reduce in a desired manner the risk of an uncontrolled fracture of the multiple substrate 1 along the predetermined fracture lines 4 during its singulation. Due to a notch effect, the apertures 9 apply a local stress concentration to the respective groove of each corresponding predetermined fracture line 4 at the transition from the predetermined fracture lines 4 to the respective aperture 9, such that the probability of an uncontrolled fracture in the region of the aperture 9, which bevels the respective corners of each single substrate 3, is reduced or even completely eliminated. Furthermore, the dimensions of apertures 9 or 10 can already be kept small by inserting them into the multiple substrate 1, since the thus bevelled corners of the single substrates 3 do not have to be fractured manually after singulation, as is the case in the above-described state of the art.

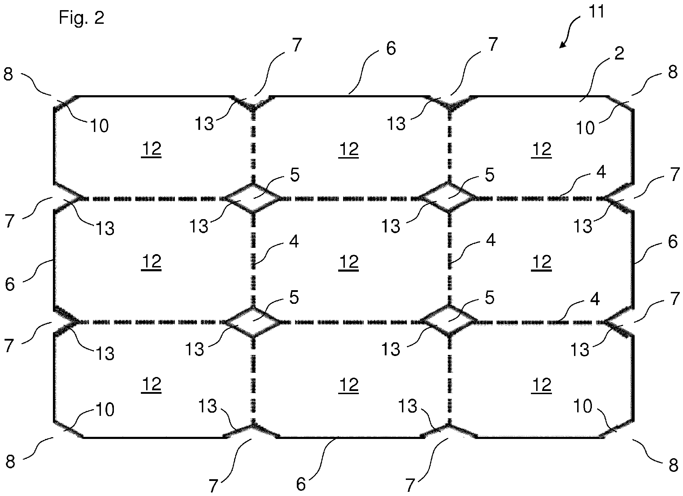

Fig. 2 shows a top view of a second embodiment of a multiple substrate 11 according to the invention. The essentially rectangular multiple substrate 11, on whose brittle-fracture layer 2 nine single substrates 12 are also integrally adjoined by the predetermined fracture lines 4 delineating each other above these, essentially only differs from the embodiment of the multiple substrate 1 shown in Fig. 1 in that in this case, every corner of the essentially rectangular single substrate 12 is bevelled by an aperture 13 or 10. In contrast, in the multiple substrate 1 shown in Fig. 1 only a single corner of each single substrate 3 is bevelled by the aperture 9 or 10. Here, the apertures 13 border on at least one of the four predetermined fracture lines 4, while the apertures 10 border on two of the four outside edges 6 of the multiple substrate 11.

As is indicated in Fig. 2, the reference number 5 also means - as in Fig. 1 - the intersection point of two predetermined fracture lines 4, the reference number 7 also means the intersection point between a predetermined fracture line 4 and an outside edge 6; and the reference number 8 also means the intersection point of two outside edges 6 of the multiple substrate 11. These intersection points 5, 7 and 8 follow from the imagined extensions of the respective predetermined fracture lines 4 and the outside edges 6, not shown in Fig. 2, to clarify that there is no material of the brittle-fracture layer 2 at the intersection points 5, 7 and 8, due to the apertures 13 or 10 arranged around these.

As Fig. 2 clearly shows, each aperture 13 arranged about an intersection point 5 can be regarded as a single diamond-shaped aperture. However, it can also be regarded as four adjoining triangular apertures 9 as shown in Fig. 1. In a similar fashion, each aperture 13 arranged about an intersection point 7 can be regarded as a single triangular aperture or as two adjoining triangular apertures 9 as shown in Fig. 1. The apertures 10 arranged about intersection points 8 in the brittle-fracture layer 2 of the multiple substrate 11 shown in Fig. 2 are equivalent to the apertures 10 of the multiple substrate shown in Fig. 1.

In any case, in the embodiment of the multiple substrate 11 shown in Fig. 2, the apertures 13 and 19 are delineated completely by a traverse.

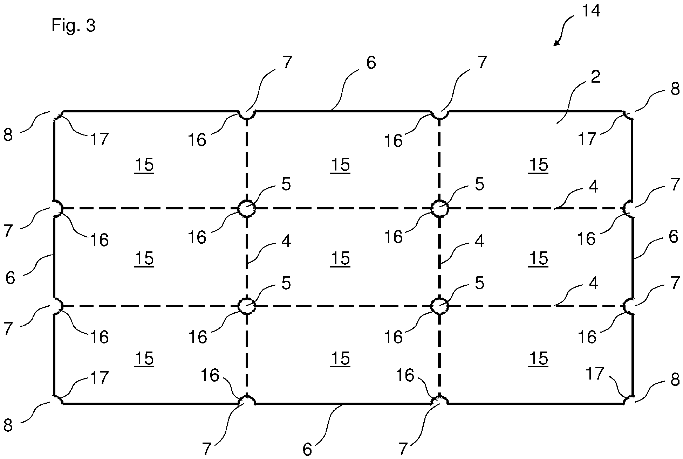

Fig. 3 shows a top view of a third embodiment of a multiple substrate 14 according to the invention. The also essentially rectangular multiple substrate 14 on whose brittle-fracture layer 2 nine single substrates 15 are also integrally adjoined, delineated from each other by predetermined fracture lines 4, essentially differs from the embodiment of multiple substrate 11 shown in Fig. 2 only in that apertures 16, which border on at least one of the predetermined fracture lines 4, and apertures 17 which border on two outside edges 6 of the multiple substrate 14, are completely delineated by a curvature.

Also in the embodiment of the multiple substrate 14 shown in Fig. 3, each aperture 16 arranged about an intersection point 5 can be regarded as a single fully circular aperture. However, it can also be regarded as four quadrant-shaped apertures bordering each other, whereby each quadrant-shaped aperture is assigned, each at another corner of four individual substrates 15, which abut at this intersection, point 5. In similar fashion, each aperture 16 arranged about an intersection point 7 can be regarded as a single semi-circular aperture or as two quadrant-shaped apertures bordering each other, each assigned to another corner of two single substrates 15, which abut each other at this intersection point 7. The apertures 17 arranged about intersection point 8 in the brittle-fracture layer 2 of the multiple substrate 14 shown in Fig. 3 are all quadrant-shaped.

Thus, each corner of the otherwise essentially rectangular single substrates 15 of the multiple substrate 14 shown in Fig. 3 is concave, i.e. rounded with the curvature toward the inside of each single substrate 15.

Similarly to the embodiment of multiple substrate 1 shown in Fig. 1, only a single corner of each otherwise essentially rectangular single substrate of a multiple substrate (not shown) can be provided for example with a quadrant-shaped aperture similar to aperture 17 shown in Fig 3, functioning as a Poka Yoke, i.e. an aperture at least partially delineated by a curvature in contrast to a an aperture 9 of multiple substrate 1 only delineated by a traverse, as shown in Fig. 1.

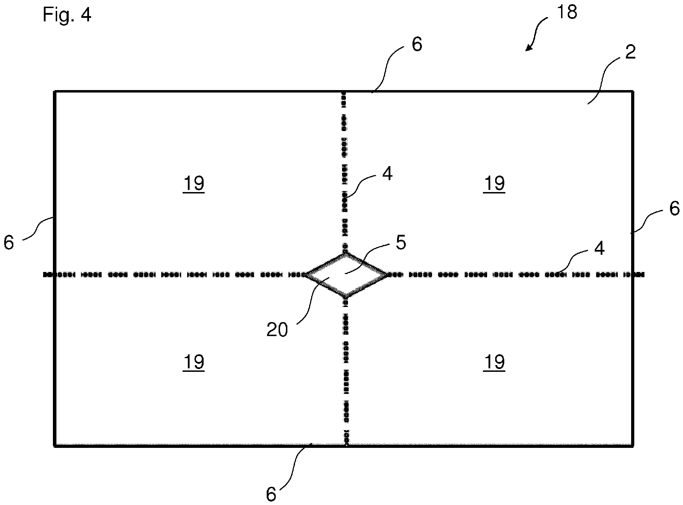

Fig. 4 shows a top view of a fourth embodiment of a multiple substrate 18 according to the invention. The multiple substrate 18 is formed of an essentially rectangular brittle-fracture plate such as a ceramic or glass plate, or a brittle-fracture layer 2 such as a ceramic or glass layer, which in the embodiment shown in Fig. 4 forms a group of four single substrates 19 integrally adjoining each other, whereby adjoining single substrates 19 are adjoining each other by the predetermined fracture line 4 provided in brittle-fracture layer 2. In total, two predetermined fracture lines 4 are inserted into the brittle-fracture layer 2 of the multiple substrate 18 shown in Fig. 4. The predetermined fracture lines 4 are shown as dotted lines; in the embodiment of the multiple substrate 18 shown in Fig. 4, they run straight, whereby the one predetermined fracture line 4 shown in Fig. 4 runs horizontally and the other predetermined fracture line 4 runs vertically. The horizontal predetermined fracture line 4 intersects the vertical predetermined fracture line 4 at right angles in the intersection point 5. Thus the essentially rectangular multiple substrate 18 shown in Fig. 4 has a total of four single substrates 19 which are also essentially rectangular and are arranged in star-shaped form about their common intersection point 5.

As is also shown in Fig. 4, an aperture 20 is arranged about the common intersecting point 5 bordering both predetermined fracture lines 4 and completely perforating the brittle-fracture layer 2. In the shown embodiment, the aperture 20 is completely delineated by a traverse. However, the aperture 20 could also be delineated by a curvature and for example assume essentially the form which aperture 16 has in Fig. 3, i.e. such as a fully circular form.

As already described for Fig. 2 and 3, in the case shown in Fig. 4, the aperture 20 arranged about the intersecting point 5 can also be regarded either as a single diamond-shaped aperture or as four individual triangular apertures 9 bordering each other, as shown in Fig. 1, whereby each triangular aperture is assigned to another corner of each single substrate 19, each bevelled as shown in Fig. 4.

The special advantage of the embodiment of the multiple substrate 18 shown in Fig. 4 is that the four single substrates 19 abutting in intersection point 5 can be provided with only one aperture 20, each with a Poka Yoke, similar to the case shown in Fig. 1, while with the multiple substrate 1 shown in Fig 1, each single substrate 3 had to be provided with an aperture 9 or 10 in order to provide each single substrate 3 with a Poka Yoke.

It must be noted here that in the top view of the multiple substrate 18 shown in Fig. 4, the front is seen of the top left single substrate 19 while the rear is seen of the top of right single substrate 19, as it would be, for example, after a rotation of the top left single substrate 19 about the vertical predetermined fracture line 4, and the back is seen of single substrate as it would be, for example, after a rotation of the top left single substrate 19 about the horizontal predetermined fracture line 4, and the front is seen of the right bottom single substrate 19, as it would be seen, for example, after a 180° rotation of the top left single substrate 19 about a high axis perpendicular to the image plane and through intersecting point 5.

In other words, after singulation of the multiple substrate 18 shown in Fig. 4, the bottom left and the bottom right single substrates 19 are first rotated into the position of the top left single substrate shown 19 shown in Fig. 4, such as to make it possible that the four single substrates 19 obtained from the multiple substrate 18 can be further processed in a uniform manner.

Of course a multiple substrate not shown in the figures can also be formed of any number of integral connecting arrangements of the multiple substrate 18 shown in Fig. 4, such that such a multiple substrate has a whole-multiple number of versions according to the number of consecutive groups or, for example, four single substrates 19 integrally joining each other, such as shown in Fig. 4. In that case, each group as shown in Fig. 4 of star-shaped single substrates 19 arranged about a common intersecting point 5 has only one aperture 20, for example as shown in Fig. 4.

The manufacture of the multiple substrates here described and shown in Fig. 1-4 as examples 1, 11, 14 and 18 can be accomplished essentially by inserting into each brittle-fracture plate such as a ceramic or glass plate or a brittle-fracture layer 2 such as a ceramic or glass layer forming the respective multiple substrate 1, 11, 14 and 18 predetermined fracture lines 4 for example by laser scribing or mechanical etching of the brittle-fracture layer 2, to facilitate that the single substrates 3, 12, 15 or 19 are integrally bordering each other on the respective multiple substrate 1, 11, 14 or 18, and to facilitate the singulation of the multiple substrates 1, 11, 13 and 18 into the single substrates 3, 12, 15 or 19 by fracturing them along the predetermined fracture line 4. Furthermore, at least one aperture 9, 13, 16, 20 bordering a respective predetermined fracture line 4 and completely perforating the brittle-fracture layer 2 is inserted into the multiple substrates 2, 12, 15 and 19. In addition, one aperture 10 or 17 each can be inserted into the brittle-fracture layer 2 at two intersecting outside edges of the respective multiple substrate 1, 11, 13 or 18.

It is especially preferred to insert the predetermined fracture line/s 4 and the aperture/s 9, 10, 13, 16, 17 and 20 into the brittle-fracture layer 2 by means of a single laser, whereby the laser is alternated between a scribing mode for inserting the predetermined fracture line/s 4 and a cutting mode for inserting the aperture/s 9, 10, 13, 16, 17 or 20.

The above described inventive multiple substrates and the method of their fabrication are not limited to the embodiments disclosed here, but also comprise other embodiments of the same function. In particular, the multiple substrates 1, 11, 14 and 18 shown in Fig. 1-3 are not limited to the single substrates shown in Fig. 1-3, but of course can contain any number of single substrates, namely more than nine or less than nine. In addition, the multiple substrate 18 shown in Fig. 4 is not limited only to four single substrates, but can comprise any number of integral multiples of four single substrates.

In a preferred embodiment, the inventive multiple substrate, in particular the multiple ceramic or glass substrate, is used in the fabrication of electric semiconductors, in particular power circuits or LED glass windows.

### List of reference numbers:

1. multiple substrate
2. brittle-fracture layer
3. single substrate
4. predetermined fracture line
5. intersection point of two predetermined fracture lines
6. outside edge
7. intersection point of a predetermined fracture line and an outside edge
8. intersection point of two outside edges
9. aperture bordering at least one predetermined fracture line
10. aperture bordering two outside edges
11. multiple substrate
12. single substrate
13. aperture bordering at least one predetermined fracture line
14. multiple substrate
15. single substrate
16. aperture bordering at least one predetermined fracture line
17. aperture bordering two outside edges
18. multiple substrate
19. single substrate
20. aperture bordering two predetermined fracture lines

## Claims

1. A multiple substrate with a brittle-fracture plate or brittle-fracture layer (2) forming at least two individual adjoining and integrally adjoining substrates (3, 12, 15, 19) which adjoin each other by at least one predetermined fracture line (4) provided in the brittle-fracture layer (2),
**characterized in that**
bordering the predetermined fracture line (4), at least one aperture (9, 13, 16, 20) which materially separates the single substrates (3, 12, 15, 19) which are adjoining each other, is inserted into the brittle-fracture layer (2), which it completely perforates.

2. The multiple substrate according to Claim 1,
**characterized in that**
the maximum extent of the aperture (9, 13, 16, 2) along the predetermined fracture line (4) is a length which does not exceed half of the length of the edges of the single substrates (3, 12, 15, 19) adjoining each other by them, which edges are determined by the predetermined fracture line (4).

3. The multiple substrate according to Claim 1 or 2,
**characterized in that**
at least two intersecting predetermined fracture lines (4) are provided, and the aperture (9, 13, 16, 20) is arranged at the intersection point (5) of the predetermined fracture lines (4).

4. The multiple substrate according to one of the preceding claims,
**characterized in that**
at least one group of at least four single substrates (19) has a common intersection point (5) formed by at least two intersecting predetermined fracture lines (4) at which point all single substrates (19) of the group border each other, and that each group has only one aperture (2) that is
arranged at the common intersection point (5).

5. The multiple substrate according to one of the preceding claims,
**characterized in that**
the predetermined fracture line (4) intersects an outside edge (6) of the brittle-fracture layer (2), and that the aperture (9, 13, 16) is arranged at the intersection point (7) between the predetermined fracture line (4) and the outside edge (6).

6. The multiple substrate according to one of the preceding claims,
**characterized in that**
two outside edges (6) of the brittle-fracture layer (2) intersect, and another aperture (10, 17) completely perforating the brittle-fracture layer (2) is arranged at the intersection point (8) of the two outside edges (6).

7. The multiple substrate according to one of the preceding claims,
**characterized in that**
the aperture (9, 10, 13, 16, 17, 20) is partially delineated by at least one traverse.

8. The multiple substrate according to one of the preceding claims,
**characterized in that**
the aperture (9, 10, 13, 16, 17, 20) is at least partially delineated by a curvature.

9. A Method for fabricating a multiple substrate (1, 11, 14, 18) with a brittle-fracture plate or brittle-fracture layer (2) in which at least one predetermined fracture line (4) is inserted into the brittle-fracture layer (2) by which at least two integrally adjoining single substrates (3, 12, 15, 19) are adjoining each other,
**characterized in that**
bordering the predetermined fracture line (4) at least one aperture (9, 13, 16, 20) is inserted into the brittle-fracture layer (2), which aperture completely perforates the single substrates (3, 12, 15, 19) that are adjoining each other via the predetermined fracture line (4), and is materially separating them.

10. The method according to Claim 9,
**characterized in that**
the predetermined fracture line (4) and the aperture (9, 13, 16, 20) are inserted into the brittle-fracture layer (2) by means of a single laser which is being alternated between a scribing mode for inserting the predetermined fracture line (4) and a cutting mode for inserting the aperture (9, 13, 16, 29).

11. The method according to Claim 9 or 10,
**characterized in that**
at least two intersecting predetermined fracture lines (4) are inserted into the brittle-fracture layer (2) and that the aperture (9, 13, 16, 20) is inserted into the brittle-fracture layer (2) at the intersection point (5) of the predetermined fracture lines (4).

12. The method according to Claim 9 to 11,
**characterized in that**
the predetermined fracture line (4) is cut into an outside edge (6) of the brittle-fracture layer (2), and the aperture (9, 13, 16, 20) is inserted into the brittle-fracture layer (2) at the intersection point (7) of the predetermined fracture line (4) with the outside edge (6).

13. The method according to Claim 9 to 12,
**characterized in that**
another aperture (10, 17) completely perforating the brittle-fracture layer (2) is inserted at an intersection point (8) of two intersecting outside edges (6) of the brittle-fracture layer (2).

14. The method according to Claim 9 to 13,
**characterized in that**
the aperture (9, 10, 13, 16, 17, 20) is formed at least partially by a traverse.

15. The method according to Claim 9 to 14,
**characterized in that**
the aperture (9, 10, 13, 16, 17, 20) is formed at least partially by a curvature.
